# FASCICULE DE BREVET EUROPEEN

(11) **EP 2 537 189 B1**
(45) Date de publication et mention de la délivrance du brevet: **28.10.2015**
(21) Numéro de dépôt: 11702843.1
(22) Date de dépôt: 11.02.2011
(51) Int. Cl.: H01L 31/055

(54) **MODULES PHOTOVOLTAÏQUES POUR SERRE AGRICOLE ET PROCEDE DE FABRICATION DE TELS MODULES**
PV-MODULE FÜR EIN LANDWIRTSCHAFTLICHES GEWÄCHSHAUS UND VERFAHREN ZUR HERSTELLUNG DERARTIGER MODULE
PHOTOVOLTAIC MODULES FOR AN AGRICULTURAL GREENHOUSE AND METHOD FOR MAKING SUCH MODULES

(30) Priorité: 19.02.2010 FR 1000696
(43) Date de publication de la demande: 26.12.2012
(73) Titulaire: Laboratoire De Physique Du Rayonnement Et De La Lumiére, 75015 Paris (FR)
(72) Inventeur: GRAVISSE, Philippe Edouard, F-75015 Paris (FR); LE POULL, François, F-22300 Lannion (FR)
(74) Mandataire: Fidal Innovation
(86) Numéro de dépôt international: PCT/EP2011/052012
(87) Numéro de publication internationale: WO 2011/101290

(56) Documents cités:
- EP-A1- 1 688 033
- JP-A- 2009 129 686
- US-A- 4 088 508
- SARTI D ET AL: "transformation du rayonnement solaire par fluorescenceL application a l'encapsulation des cellules", SOLAR CELLS,, vol. 4, 1 janvier 1981 (1981-01-01), pages 25-35, XP002612632,

## Description

### DOMAINE DE L'INVENTION

L'invention est relative à des modules photovoltaïques pour serre agricole permettant de favoriser la culture d'espèces végétales.

### DESCRIPTION DE L'ART ANTERIEUR

Dans les techniques de réalisation de modules photovoltaïques classiques, il est connu de disposer des cellules photovoltaïques, généralement opaques et traitées anti-reflets, dans des matériaux à transmittance élevée dans le spectre solaire en face avant et fortement réflecteurs en face arrière pour servir d'écran de protection.

A l'initiative de certains industriels, l'utilisation des générateurs photovoltaïques se généralise et leurs applications intéressent de plus en plus le domaine agricole, où ils sont apposés sur les toits des bâtiments ruraux ou sur des serres agricoles.

EP1688033 décrit un élément de couverture pour serre comprenant des modules photovoltaïque.

Les modules photovoltaïques utilisés, disposés sur des serres agricoles, entrent en compétition avec les espèces végétales pour l'utilisation de la lumière solaire disponible qui bénéficie alors en priorité à la fonction photovoltaïque des modules photovoltaïques au détriment de la photosynthèse et de la croissance des espèces végétales. Le compromis généralement utilisé par les serristes ou agronomes est alors d'occulter le versant Nord de des serres agricoles pour y disposer les modules photovoltaïques en laissant l'énergie solaire entrer dans la serre par les autres côtés pour permettre la croissance des espèces végétales. Ce compromis est pénalisant pour la fonction photovoltaïque qui ne reçoit alors qu'une lumière indirecte sur la face Nord, de même que les cultures sous les serres sont privées de l'énergie diffuse de l'albédo issue de la voute céleste Nord dont la contribution à la croissance des espèces végétales n'est pas négligeable.

La présente invention vise notamment un module photovoltaïque pour serre agricole permettant de favoriser la culture d'espèces végétales.

### BREVE DESCRIPTION DE L'INVENTION

Selon un premier aspect de la présente invention, un module photovoltaïque pour serre agricole comprend une plaque avant destinée à être en contact avec la lumière solaire, un substrat arrière et un ensemble dé cellules photovoltaïques disposées entre la plaque avant et le substrat arrière. Le module photovoltaïque a un coefficient de foisonnement compris sensiblement entre 0,2 et 0,8, et comprend au moins une couche d'un matériau dopé cascade lumineuse favorisant la photosynthèse susceptible d'absorber la lumière solaire dans au moins une plage de longueurs d'onde pour la réémettre dans au moins une deuxième plage de longueurs d'onde favorables à la photosynthèse d'au moins une espèce végétale.

Selon une variante du premier objet de la présente invention, l'un au moins de la plaque avant et du substrat arrière forme ou est revêtu de la couche de matériau dopé cascade lumineuse favorisant la photosynthèse.

Selon une autre variante du premier objet de la présente invention, l'ensemble des cellules photovoltaïques sont disposées dans une matrice organique ou entre deux films organiques.

Selon une autre variante du premier objet de la présente invention, l'un au moins de la matrice organique et des deux films organiques forme la couche de matériau dopé cascade lumineuse favorisant la photosynthèse.

Selon une autre variante du premier objet de la présente invention, le matériau dopé cascade lumineuse favorisant la photosynthèse absorbe la lumière solaire dans la plage de longueurs d'onde 300 à 400 nm pour la réémettre dans la plage de longueurs d'onde 410 à 500 nm.

Selon une autre variante du premier objet de la présente invention, le matériau dopé cascade lumineuse favorisant la photosynthèse absorbe la lumière solaire dans la plage de longueurs d'onde 510 à 590 nm pour la réémettre dans la plage de longueurs d'onde 600 à 750 nm.

Selon une autre variante du premier objet de la présente invention, la plaque avant et le substrat arrière du module photovoltaïque comprennent du verre, et au moins l'un de la plaque avant et du substrat arrière est revêtu de la couche de matériau dopé cascade lumineuse favorisant la photosynthèse.

Selon une autre variante du premier objet de la présente invention, la plaque avant et le substrat arrière du module photovoltaïque comprennent du polyméthacrylate de méthyle, et au moins l'un de la plaque avant et du substrat arrière forme la couche de matériau dopé cascade lumineuse favorisant la photosynthèse.

Selon une autre variante du premier objet de la présente invention, le substrat arrière forme ou est revêtu de la couche de matériau dopé cascade lumineuse photosynthèse, et la plaque avant du module photovoltaïque forme ou est revêtue d'une couche d'un matériau dopé cascade lumineuse favorisant la fonction photovoltaïque susceptible d'absorber la lumière solaire dans au moins une plage de longueurs d'onde pour la réémettre dans au moins une deuxième plage de longueurs d'onde de plus grande sensibilité des cellules photovoltaïques.

Selon une encore une autre variante du premier objet de la présente invention, la couche de matériau dopé cascade lumineuse favorisant la fonction photovoltaïque ou favorisant la photosynthèse comprend une matrice comprenant au moins un composé choisi dans le groupe comprenant les silicones, les polycarbonates, l'éthylène-acétate de vinyle, le polyéthylène, le polyméthacrylate de méthyle, le polyvinyle butyrale, les verres, et leurs dérivés.

Selon une variante du premier objet de la présente invention, le matériau dopé cascade lumineuse favorisant la fonction photovoltaïque ou la photosynthèse comprend au moins un composé choisi dans le groupe comprenant les lanthanides, l'ion uranyl, les composés cycliques aromatiques du type à N noyaux, N étant un entier choisi parmi 3, 4, 5 ou plus, et leurs dérivés.

Selon un deuxième aspect de la présente invention, une serre agricole est recouverte sur au moins une partie de sa surface par au moins un module photovoltaïque selon le premier objet de la présente invention.

Selon un troisième aspect de l'invention, un procédé de fabrication de modules photovoltaïques du type comprend une plaque avant destinée à être en contact avec la lumière solaire, un substrat arrière et un ensemble de cellules photovoltaïques disposées entre la plaque avant et le substrat arrière Le procédé comprend au moins les étapes de répartition des cellules photovoltaïques sur le substrat arrière afin que le module photovoltaïque obtenu ait un coefficient de foisonnement compris sensiblement entre 0,2 et 0,8, et d'incorporation dans ou revêtement sur l'un au moins de la plaque avant et du substrat arrière d'un matériau dopé cascade lumineuse favorisant la photosynthèse susceptible d'absorber la lumière solaire dans au moins une plage de longueurs d'onde pour la réémettre dans au moins une deuxième plage de longueurs d'onde favorables à la photosynthèse d'au moins une espèce végétale.

### BREVE DESCRIPTION DES DESSINS

D'autres avantages et caractéristiques de l'invention apparaitront à la lecture de la description qui suit, illustrée par les figures suivantes:
- la Figure 1 représente une vue de dessus d'un module photovoltaïque selon un mode de réalisation de la présente invention.
- la Figure 2 est un graphique représentant la réponse spectrale des deux types de chlorophylle présents dans les espèces végétales.
- la Figure 3 est un schéma représentant le principe de fonctionnement d'une cascade lumineuse.
- la Figure 4 est un graphique représentant le spectre solaire et le spectre solaire modifié par un module photovoltaïque comprenant un matériau dopé cascade lumineuse favorisant la photosynthèse selon un mode de réalisation de la présente invention.
- la Figure 5 est un graphique représentant le spectre solaire et le spectre solaire modifié par un module photovoltaïque comprenant un matériau dopé cascade lumineuse favorisant la fonction photovoltaïque selon un mode de réalisation de la présente invention.
- les Figures 6a à 6d sont des coupes transversales de modules photovoltaïques selon des modes de réalisation de la présente invention.
- la Figure 7 représente un exemple de serre agricole recouverte de plusieurs modules photovoltaïques selon un mode de réalisation de la présente invention.

### DESCRIPTION DETAILLEE

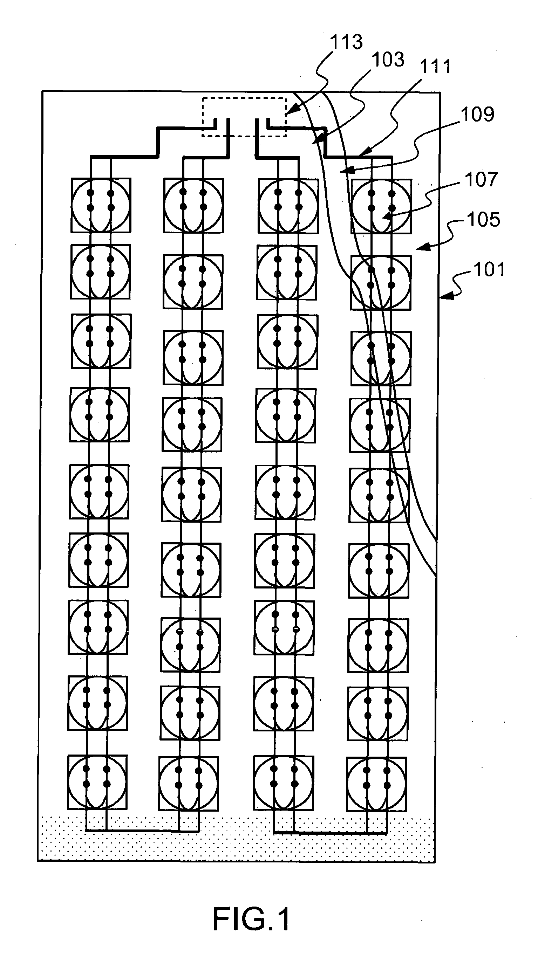

La Figure 1 représente un module photovoltaïque selon un mode de réalisation de l'invention. Le module photovoltaïque 101 comprend une plaque avant ou extérieure 103 destinée à recevoir la lumière solaire, un substrat arrière ou intérieur 105, ainsi qu'un ensemble de cellules photovoltaïques 107 disposées entre la plaque avant 103 et le substrat arrière 105 du module photovoltaïque.

Selon un mode de réalisation de la présente invention, la plaque avant 103 et le substrat arrière 105 du module photovoltaïque 101 comprennent chacun au moins un composé choisi dans le groupe comprenant les silicones, les polymères fluorés, les polycarbonates, l'éthylène-acétate de vinyle (EVA), le polyéthylène (PE), le polyméthacrylate de méthyle (PMMA), le polyvinyle butyrale (PVB), les verres, tel que les verres au phosphate, silicate ou borosilicate, et leurs dérivés.

Selon un mode de réalisation de la présente invention, la plaque avant 103 et le substrat arrière 105 ont une épaisseur moyenne comprise entre 0,5 et 5 mm.

Selon un mode de réalisation de la présente invention, les cellules photovoltaïques 107 sont du type diode à jonction de grande surface, du type unijonction ou multijonction. Les cellules photovoltaïques 107 sont du type au silicium, tel que du silicium amorphe, monocristallin ou multicristallin, ou du type CdTe ou CISG (Cuivre-indium-sélénium-gallium).

L'ensemble des cellules photovoltaïques 107 du module photovoltaïque 101 selon un mode de réalisation de l'invention sont disposées entre deux films organiques ou dans une matrice organique 109. Cette matrice organique 109 ou ces films organiques comprennent au moins un composé choisi dans le groupe comprenant les silicones, les polymères fluorés, les polycarbonates, l'éthylène-acétate de vinyle (EVA), le polyéthylène (PE), le polyméthacrylate de méthyle (PMMA), le polyvinyle butyrale (PVB), les verres, tel que les verres au phosphate, silicate ou borosilicate, et leurs dérivés.

Selon un mode de réalisation de la présente invention, la matrice organique 109 a une épaisseur moyenne comprise entre 2.5 et 4 mm. Dans un mode de réalisation de l'invention, les films organiques ont une épaisseur moyenne comprise entre 200 et 600 µm.

Chaque cellule photovoltaïque 107 possède par exemple une tension nominale constante de 0.5V. La puissance des cellules photovoltaïques 107 dépend de l'intensité du courant généré qui dépend de la surface de chaque cellule photovoltaïque 107. Un module photovoltaïque 101 selon un mode de réalisation de l'invention permet ainsi de générer une tension de l'ordre de 19V pour pouvoir servir une batterie de charge électrochimique de 12-15V. Un module photovoltaïque 101 peut comprendre typiquement 40 cellules photovoltaïques 107.

Selon un mode de réalisation de la présente invention, les cellules photovoltaïques 107 du module photovoltaïque 101 sont connectées par des connecteurs électriques 111, par exemple en cuivre étamé, entre elles en série et à une boîte de connexion 113 associée au module photovoltaïque 101.

Dans une application du module photovoltaïque 101 à la couverture de serre agricole, la quantité d'énergie lumineuse entrant dans une serre agricole pour la croissance des espèces végétales et la quantité de courant photovoltaïque délivrée par l'ensemble des cellules photovoltaïques 107 sont déterminées par le "coefficient de foisonnement" d'un module photovoltaïque 101. Le coefficient de foisonnement du module photovoltaïque 101 est défini par le rapport de la surface de l'ensemble des cellules photovoltaïques 107 sur la surface totale de collection de photons du module photovoltaïque 101.

La déposante a montré qu'un coefficient de foisonnement inférieur à 1, avantageusement compris entre 0,2 et 0,8, permet d'assurer la fonction photovoltaïque des cellules photovoltaïques 107 tout en favorisant l'illumination des espèces végétales. Selon un autre mode de réalisation de l'invention, le coefficient de foisonnement est compris entre 0,4 et 0,6.

La déposante a notamment avantageusement montré que les modules photovoltaïques 101 selon un mode de réalisation de l'invention, dans lequel le coefficient de foisonnement des modules photovoltaïques est de 0.5 et dans lequel les modules photovoltaïques comprennent une couche de matériau dopé cascade lumineuse favorisant la photosynthèse, permettent une augmentation de rendement de l'ordre de 50% en éclairement diffus et que par ailleurs les espèces végétales cultivées sous des serres agricoles recouvertes du module photovoltaïque 101 connaissent des rendements de production pouvant aller de 1,25 à 1,50 par rapport à ceux des cultures sous abris classiques.

Les cellules photovoltaïques 107 utilisées dans un module photovoltaïque 101 selon un mode de réalisation de la présente invention sont de forme carré ou circulaire, type "wafer". Dans un mode de réalisation préféré de la présente invention, l'utilisation de cellules photovoltaïques 107 de forme "wafer" donne un coefficient de foisonnement naturel, permet un meilleur ensoleillement sur des espèces végétales et permet d'éviter une perte de matière lors de la fabrication des cellules photovoltaïques 107.

Dans un mode de réalisation préféré de la présente invention, pour un rayonnement solaire normalisé de AM 1,5, la surface de couverture d'une serre agricole par un module photovoltaïque 101 est avantageusement partagée à 50% en surface de cellules photovoltaïques 107 et 50% en surface du substrat arrière ou intérieure 105 n'étant pas couvert par les cellules photovoltaïques 107. Cette configuration permet au module photovoltaïque d'avoir un coefficient de foisonnement de 0.5.

Cependant en période de déficit lumineux ou de lumière diffuse, en zone septentrionale par exemple, la priorité doit être mise sur la surface de collection de photons. On peut alors diminuer le coefficient de foisonnement du module photovoltaïque 101 et de privilégier les entrées de lumière dans la serre agricole.

En effet, dans le domaine de la physiologie végétale, outre la nécessité d'une terre fertile, d'un entretien constant d'un point vu nutritif, traitement phytosanitaire, équilibre de pH, densité, la lumière est un autre paramètre d'importance également à prendre en compte. Une quantité minimum de lumière est nécessaire pour que le processus de photosynthèse puisse s'opérer. Toutefois, un excès de lumière est à éviter pour épargner aux espèces végétales un échauffement inutile provoquant une saturation de la fonction chlorophyllienne.

Par ailleurs, la qualité spectrale de la lumière reçue par les espèces végétales est également un paramètre très important. En effet, la majorité des espèces végétales ayant des feuilles vertes n'absorbe pas ou peu les longueurs d'onde comprises dans les domaines du rayonnement ultra-violet (longueurs d'onde comprises entre 300 et 400 nm) et du rayonnement vert (longueurs d'onde comprises entre 510 et 590 nm).

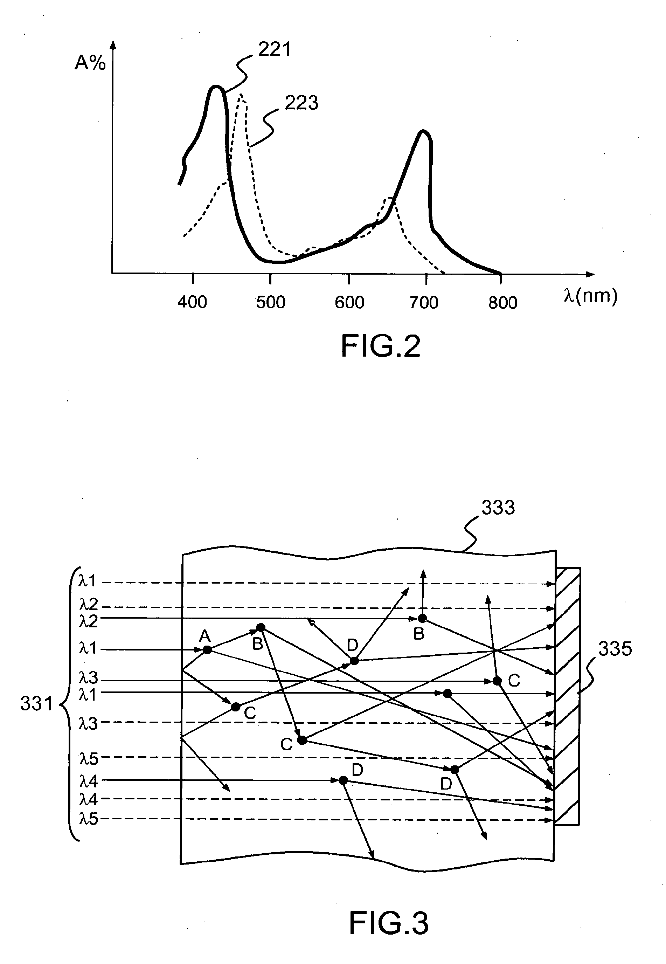

Les autres longueurs d'ondes correspondent au domaine spectrale d'absorption d'une chromoprotéine communément appelée phytochrome. Ce phytochrome existe sous deux formes d'isomères, la chlorophylle A et la chlorophylle B. La Figure 2 est un graphique (Energie relative A%=f(longueur d'onde λ)) représentant les spectres d'absorption des deux types de chlorophylle présent dans les espèces végétales. La Figure 2 montre que la chlorophylle A, courbe 221, et la chlorophylle B, courbe 223, absorbent la lumière solaire dans les domaines de rayonnement du bleu (longueurs d'onde comprises entre 410 et 500 nm) et de rayonnement du rouge (longueurs d'onde comprises entre 600 et 750 nm).

C'est au niveau de ce phytochrome que se réalise le processus de photosynthèse. Les photons sont convertis en agent réducteur (enzyme) de dioxyde de carbone et oxydant de l'eau. Ces réduction et oxydation simultanées donnent naissance à un chaînon glucidique satisfaisant aux besoins énergétiques et à la croissance des espèces végétales.

Un autre paramètre lumineux d'importance pour la croissance des espèces végétales est le photopériodisme. Le photopériodisme est déterminé par la photophase, période de sensibilité à la lumières de l'espèce végétale, à laquelle succède une scotophase, période d'insensibilité à la lumière de l'espèce végétale. Les espèces végétales peuvent être classées en trois grandes catégories vis-à-vis du photopériodisme: les espèces hémépériodiques dites de jour long, les espèces nyctipériodiques dites de jour court et les espèces indifférentes au photopériodisme.

La déposante a montré qu'en combinant un module photovoltaïque avec un coefficient de foisonnement inférieur à 1 et l'utilisation d'un matériau spécifique permettant d'optimiser la qualité spectrale de la lumière reçue par les espèces végétales, on pouvait augmenter le rendement des serres tout en gardant la fonction photovoltaïque.

La modification du spectre solaire par le module photovoltaïque 101 selon un mode de réalisation de la présente invention est effectuée grâce à la présence d'un matériau à décalage de bande, ou autrement appelé à "cascade lumineuse", susceptible d'absorber la lumière solaire dans au moins une plage de longueurs d'onde pour la réémettre dans au moins une deuxième plage de longueurs d'onde favorables à la photosynthèse des espèces végétales. Dans la suite de la description, ce type de matériau sera nommé "matériau dopé cascade lumineuse favorisant la photosynthèse".

Dans un mode de réalisation de la présente invention, le matériau dopé cascade lumineuse favorisant la photosynthèse absorbe la lumière solaire dans la plage de longueurs d'onde 300 à 400 nm pour la réémettre dans la plage de longueurs d'onde 410 à 500 nm. Le matériel dopé cascade lumineuse favorisant la photosynthèse peut également, de manière simultanée ou alternative au précédent mode de réalisation de l'invention, absorber la lumière solaire dans la plage de longueurs d'onde 510 à 590 nm pour la réémettre dans la plage de longueurs d'onde 600 à 750 nm.

Le but d'une cascade lumineuse est de mobiliser au niveau d'un élément d'intérêt le maximum d'énergie dans la plage de plus grande sensibilité spectrale de cet élément pour un maximum de rendement de cet élément.

En principe, l'énergie solaire utilisée est définie par la zone de recouvrement des spectres d'émission de la lumière solaire et de la gamme spectrale d'intérêt pour l'élément considéré. Donc, compte tenu de la spécificité de l'élément considéré et du fait que l'énergie récupérée par l'élément est fonction de l'intensité du faisceau lumineux reçu par l'élément, c'est-à-dire du nombre de photons transportés, l'un des moyens d'augmenter le rendement de l'élément considéré est de rendre utilisables les photons de la partie du spectre solaire située en dehors de la plage de plus grande sensibilité dudit élément considéré.

Le procédé utilisé, dit de "cascade lumineuse", transforme des photons ayant une longueur d'onde située en dehors de la plage de plus grande sensibilité de l'élément considéré en utilisant les propriétés luminescentes et/ou fluorescentes de certains composés chimiques, du type matériaux optiquement actifs MOA ou cristaux optiquement actifs COA, pris comme intermédiaires dans le transport de l'énergie issue de la lumière solaire.

Les composés sont choisis de façon que leurs spectres d'absorption constituent des zones successives d'absorption/émission permettant de couvrir la totalité du spectre solaire dans la zone visible (recouvrement en fréquences ou en longueurs d'ondes).

La Figure 3 représentant le principe de fonctionnement d'une cascade lumineuse. Une radiation solaire 301 de longueur d'onde déterminée λ₁, λ₂, λ₃, λ₄, λ₅ peut être absorbée par le composé chimique dont le spectre d'absorption comprend cette valeur λ₁, λ₂, λ₃, λ₄, λ₅. Les photons qui ont permis d'exciter les molécules de ce composé (phénomène d'absorption) sont ainsi extraits définitivement du faisceau lumineux incident 301. Le retour à l'état fondamental (état stable des molécules à une température donnée) peut s'effectuer en partie et de façon avantageuse par une émission radiative (fluorescence et/ou phosphorescence). Les photons ainsi engendrés se trouvent correspondre au spectre d'absorption d'un autre composé chimique qui prendra le relais.

Un composé donné peut absorber soit l'émission du composé qui le précède dans la séquence de composés utilisés, soit la partie de l'émission du spectre solaire qui lui correspond. Comme illustré par la Figure 3, la matrice dopée 333, intermédiaire entre le rayonnement solaire incident 331 de longueur d'onde λ₁, λ₂, λ₃, λ₄, λ₅ et un élément d'intérêt 335, comprend des centres actifs A, B, C, D correspondant aux divers composés MOA ou COA constituant la matrice dopée 333. A titre d'exemple, les centres actifs A convertissent les photons de longueur d'onde λ₁ correspondant au proche ultra-violet en photons de longueur d'onde λ₂ correspondant au bleu, les centres actifs B convertissent les photons de longueur d'onde λ₂ correspondant au bleu en photons de longueur d'onde λ₃ correspondant au vert, les centres actifs C convertissent les photons de longueur d'onde λ₃ correspondant au vert en photons de longueur d'onde λ₄ correspondant au jaune, et les centres actifs D convertissent les photons de longueur d'onde λ₄ correspondant au jaune en photons de longueur d'onde λ₅ correspondant au rouge. Les rayons solaires pénétrant dans la matrice dopées 333 comprennent des photons qui soit frappent l'élément d'intérêt 335 sans avoir subit de transformation (représentés par les flèches discontinues sur la Figure3), soit frappent les centres actifs A, B, C, D et/ou l'élément d'intérêt 335 ayant subit une ou plusieurs transformations (représentés par les flèches continues sur la Figure 3).

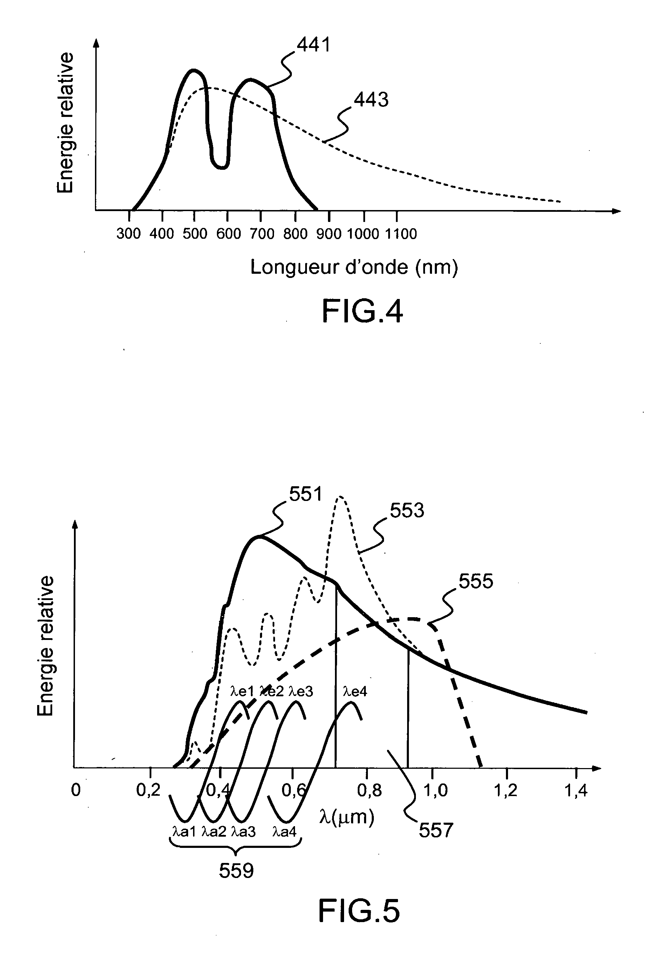

Ce principe de "cascade lumineuse" est appliqué pour favoriser la photosynthèse d'espèces végétales. La Figure 4 est un graphique (Energie relative=f(longueur d'onde)) représentant le spectre solaire 443 et le spectre solaire modifié 441 par un module photovoltaïque 101 comprenant un matériau dopé cascade lumineuse favorisant la photosynthèse selon un mode de réalisation de la présente invention.

Le module photovoltaïque 101 selon un mode de réalisation de la présente invention permet de concentrer l'ensemble des bandes de longueurs d'onde du rayonnement solaire qui sont favorables à la croissance et au développement des espèces végétales. Ceci est illustré par la Figure 4, où il est observable que le spectre solaire tel que modifié 441 par un module photovoltaïque 101 selon un mode de réalisation de l'invention absorbe la lumière solaire dans la plage de longueurs d'onde 300 à 400 nm pour la réémettre dans la plage de longueurs d'onde 410 à 500 nm, et absorbe également la lumière solaire dans la plage de longueurs d'onde 510 à 590 nm pour la réémettre dans la plage de longueurs d'onde 600 à 750 nm.

Pour modifier le spectre solaire, deux composés optiquement actifs ou plus sont dispersés dans le matériau dopé cascade lumineuse favorisant la photosynthèse afin de former une cascade lumineuse à deux niveaux ou plus. Ces composés optiquement actifs ont un pouvoir absorbant dans les longueurs d'onde non favorables à la photosynthèse des espèces végétales, *i.e*., 300 à 400 nm et 510 à 590 nm par exemple, et présentent des spectres d'absorption et d'émission se chevauchant selon le principe précédemment expliqué, de façon à obtenir le report d'énergie souhaité. Ces composés optiquement actifs doivent également être compatibles avec le matériau dopé cascade lumineuse favorisant la photosynthèse dans lequel ils sont dispersés.

Selon un mode de réalisation de l'invention, le matériau dopé cascade lumineuse favorisant la photosynthèse est compris dans ou revêtu sur l'un au moins de la plaque avant 103 et du substrat arrière 105. Alternativement, le matériau dopé cascade lumineuse favorisant la photosynthèse peut être compris dans la matrice organique 109 ou dans l'un au moins des deux films organiques entre lesquels sont disposées les cellules photovoltaïques 107.

Selon un autre mode de réalisation de l'invention, le matériau dopé cascade lumineuse favorisant la photosynthèse est revêtu sur l'un au moins de la plaque avant 103 et du substrat arrière 105. Le matériau dopé cascade lumineuse favorisant la photosynthèse comprend alors une matrice, dans un mode de réalisation de l'invention, comprenant au moins un composé choisi dans le groupe comprenant les silicones, les polymères fluorés, les polycarbonates, l'éthylène-acétate de vinyle (EVA), le polyéthylène (PE), le polyméthacrylate de méthyle (PMMA), le polyvinyle butyrale (PVB), les verres, tel que les verres au phosphate, silicate ou borosilicate, et leurs dérivés.

Dans un mode de réalisation de l'invention, les composés optiquement actifs compris dans le matériau dopé cascade lumineuse favorisant la photosynthèse sont choisis dans le groupe comprenant les lanthanides, l'ion uranyl, les composés cycliques aromatiques du type à N noyaux, N étant un entier choisi parmi 3, 4, 5 ou plus, et leurs dérivés. Selon un mode de réalisation particulier de l'invention, les lanthanides sont choisis dans le groupe comprenant le praséodyme, le néodyme, le samarium, l'europium, et leurs dérivés. Selon un mode de réalisation particulier de l'invention, les composés cycliques aromatiques du type à N noyaux sont choisis dans le groupe comprenant le diphenyl oxazole, l'uranine S, la rhodamine B, l'anthracène, le pentacène, l'uvitex MD, le naphtacène, l'hexacène, le jaune 8G, le rouge GG, et leurs dérivés.

La concentration des divers composés optiquement actifs présents dans le matériau dopé cascade lumineuse favorisant la photosynthèse dépend essentiellement de l'épaisseur de la couche de matériau dopé cascade lumineuse favorisant la photosynthèse. Ladite concentration répond à la loi de Beer-Lambert. Uniquement à titre d'exemple, pour une plaque contenant le matériau dopé cascade lumineuse favorisant la photosynthèse ayant une épaisseur de 3 mm, les concentrations des composés optiquement actifs peuvent être comprises entre 10⁻³ et 10⁻⁶ %poids. La déposante a avantageusement montré qu'une modification au niveau de la concentration desdits composés optiquement actifs entraîne un décalage et/ou un élargissement du spectre d'émission desdits composés, d'où la possibilité d'influer sur la modification du spectre solaire en jouant sur les concentrations.

La déposante a montré qu'on pouvait également, selon une variante de réalisation, favoriser la fonction photovoltaïque du module photovoltaïque 101. Pour cela, selon un mode de réalisation de la présente invention, le substrat arrière 105 du module photovoltaïque 101 comprend ou est revêtu d'un matériau dopé cascade lumineuse favorisant la photosynthèse et la plaque avant 103 du module photovoltaïque 101 comprend ou est revêtue d'un "matériau dopé cascade lumineuse favorisant la fonction photovoltaïque", qui est un matériau à décalage de bande (cascade lumineuse), susceptible d'absorber la lumière solaire dans au moins une plage de longueurs d'onde pour la réémettre dans au moins une deuxième plage de longueurs d'onde de plus grande sensibilité des cellules photovoltaïques 107. Alternativement, le matériau dopé cascade lumineuse favorisant la fonction photovoltaïque peut être compris dans la matrice organique 109 ou dans l'un au moins des deux films organiques entre lesquels sont disposées les cellules photovoltaïques 107.

Le module photovoltaïque 101 selon un mode de réalisation de la présente invention permet ainsi de décaler le spectre solaire vers les plages de longueurs d'onde de plus grande sensibilité des cellules photovoltaïques 107. Ceci est illustré par la Figure 5. La courbe 551 illustre le spectre solaire, la courbe 553 illustre le spectre d'énergie solaire transformé par un module photovoltaïque 101 selon un mode de réalisation de l'invention et la courbe 555 illustre la réponse spectrale d'une cellule photovoltaïque en silicium mono ou polycristallin. La zone 557 illustre la plage de plus grande sensibilité d'un exemple de cellule photovoltaïque en silicium mono ou polycristallin. Les courbes d'absorption et d'émission 559 de quatre composés optiquement actifs de pics d'absorption respectivement λₐ₁, λₐ₂, λₐ₃, λₐ₄ et de pics d'émission λₑ₁, λₑ₂, λₑ₃, λₑ₄ illustre un exemple de cascade lumineuse d'un matériau dopé cascade lumineuse favorisant la fonction photovoltaïque.

Pour modifier le spectre solaire, deux composés optiquement actifs ou plus sont dispersés dans le matériau dopé cascade lumineuse favorisant la fonction photovoltaïque afin de former une cascade lumineuse à deux niveaux ou plus. Ces composés optiquement actifs ont un pouvoir absorbant dans les longueurs d'onde hors du domaine de plus grande sensibilité des cellules photovoltaïques 107, et présentent des spectres d'absorption et d'émission se chevauchant selon le principe précédemment expliqué, de façon à obtenir le report d'énergie souhaité. Ces composés optiquement actifs doivent également être compatibles avec le matériau dopé cascade lumineuse favorisant la fonction photovoltaïque dans lequel ils sont dispersés.

Dans un mode de réalisation de la présente invention, les cellules photovoltaïques 107 utilisées sont du type au silicium monocristallin ou multicristallin. Dans ce cas, les composés optiquement actifs doivent absorber les longueurs d'onde 300 à 640 nm et réémettre dans le domaine 650 à 750 nm.

Selon un mode de réalisation de la présente invention, les cellules photovoltaïques 107 utilisées sont du type au silicium amorphe. Dans ce cas, les composés optiquement actifs doivent absorber les longueurs d'onde 300 à 540 nm et réémettre dans le domaine 550 à 650 nm.

Lorsque le matériau dopé cascade lumineuse favorisant la fonction photovoltaïque est revêtu sur l'un au moins de la plaque avant 103 et du substrat arrière 105, il comprend une matrice comprenant au moins un composé choisi dans le groupe comprenant les silicones, les polymères fluorés, les polycarbonates, l'éthylène-acétate de vinyle (EVA), le polyéthylène (PE), le polyméthacrylate de méthyle (PMMA), le polyvinyle butyrale (PVB), les verres, tel que les verres au phosphate, silicate ou borosilicate, et leurs dérivés.

Dans un mode de réalisation de l'invention, les composés optiquement actifs compris dans le matériau dopé cascade lumineuse favorisant la fonction photovoltaïque sont choisis dans le groupe comprenant les lanthanides, l'ion uranyl, les composés cycliques aromatiques du type à N noyaux, N étant un entier choisi parmi 3, 4, 5 ou plus, et leurs dérivés. Selon un mode de réalisation particulier de l'invention, les lanthanides sont choisis dans le groupe comprenant le praséodyme, le néodyme, le samarium, l'europium, et leurs dérivés. Selon un mode de réalisation particulier de l'invention, les composés cycliques aromatiques du type à N noyaux sont choisis dans le groupe comprenant le diphenyl oxazole, l'uranine S, la rhodamine B, l'anthracène, le pentacène, l'uvitex MD, le naphtacène, l'hexacène, le jaune 8G, le rouge GG, et leurs dérivés.

La concentration des divers composés optiquement actifs présents dans le matériau dopé cascade lumineuse favorisant la photosynthèse dépend essentiellement de l'épaisseur de la couche de matériau dopé cascade lumineuse favorisant la photosynthèse. Ladite concentration répond à la loi de Beer-Lambert. Uniquement à titre d'exemple, pour une plaque contenant le matériau dopé cascade lumineuse favorisant la photosynthèse ayant une épaisseur de 3 mm, les concentrations des composés optiquement actifs peuvent être comprises entre 10⁻³ et 10⁻⁶ %poids. Une modification au niveau de la concentration desdits composés optiquement actifs entraîne un décalage et/ou un élargissement du spectre d'émission desdits composés, d'où la possibilité d'influer sur la modification du spectre solaire en jouant sur les concentrations.

Selon une variante de réalisation de la présente invention, le module photovoltaïque 101 comprend un matériau à la fois dopé cascade lumineuse favorisant la photosynthèse et dopé cascade lumineuse favorisant la fonction photovoltaïque.

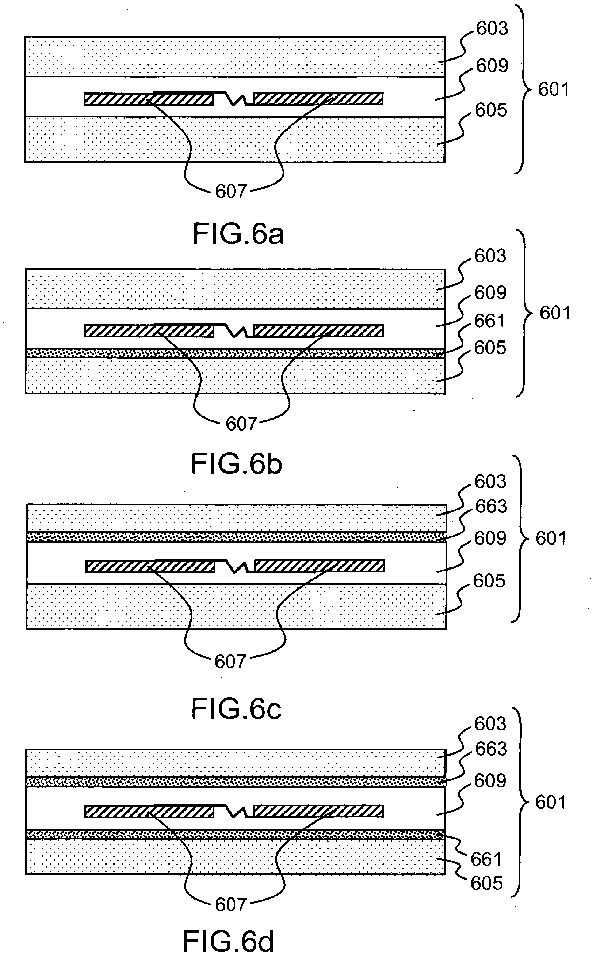

Un module photovoltaïque selon des modes de réalisation de la présente invention va maintenant être décrit en référence au Figures 6a à 6d. Ces modes de réalisation du module photovoltaïque ne sont donnés qu'à titre d'exemple et ne constituent pas une limitation de l'objet de la présente invention. Les Figures 6a à 6d sont des coupes transversales de modules photovoltaïques selon des modes de réalisation de la présente invention.

Selon un mode de réalisation de la présente invention, illustré par la Figure 6a, un module photovoltaïque 601 comprend un substrat arrière 605" une plaque avant 603, et un ensemble de cellules photovoltaïques 607 disposées dans une matrice organique 609 disposée entre la plaque avant 603 et le substrat arrière 605.

Dans une première variante de ce mode de réalisation, la plaque avant 605 comprend un matériau dopé cascade lumineuse favorisant la photosynthèse, la matrice organique 609 et le substrat arrière 605 comprenant un matériau transparent neutre.

Dans une seconde variante de ce mode de réalisation, le substrat arrière 605 comprend un matériau dopé cascade lumineuse favorisant la photosynthèse, la matrice organique 609 et la plaque avant 603 comprenant un matériau transparent neutre. De manière concomitante à cette seconde variante, la plaque avant 603 et/ou la matrice organique 609 peuvent comprendre un matériau dopé cascade lumineuse favorisant la fonction photovoltaïque.

Dans une troisième variante de ce mode de réalisation, la matrice organique 609 comprend un matériau dopé cascade lumineuse favorisant la photosynthèse, le plaque avant 603 et le substrat arrière 605 comprenant un matériau transparent neutre. De manière concomitante à cette troisième variante, la plaque avant 603 peut comprendre un matériau dopé cascade lumineuse favorisant la fonction photovoltaïque.

Dans toutes les variantes de ce mode de réalisation de l'invention, la matrice organique 609 peut être remplacée par deux films organiques entre lesquels sont disposées les cellules photovoltaïques.

Selon un mode de réalisation de la présente invention, illustré par la Figure 6b, un module photovoltaïque 601 comprend un substrat arrière 605 comprenant un matériau transparent neutre et revêtu d'un film 661 de matériau dopé cascade lumineuse favorisant la photosynthèse, une plaque avant 603 comprenant un matériau transparent neutre, et un ensemble de cellules photovoltaïques 607 disposées dans une matrice organique 609 comprenant un matériau transparent neutre et disposée entre la plaque avant 603 et le substrat arrière 605.

Selon une première variante de ce mode de réalisation de la présente invention, l'une au moins de la matrice organique 609 et de la plaque avant 603 comprend un matériau dopé cascade lumineuse favorisant la fonction photovoltaïque.

Dans une seconde variante de ce mode de réalisation de l'invention, la matrice organique peut être remplacée par deux films organiques entre lesquels sont disposées les cellules photovoltaïques 607. Dans ce cas, le film organique inférieur vient se substituer au film 661 de matériau dopé cascade lumineuse favorisant la photosynthèse. Le film organique supérieur peut dans une variante supplémentaire de ce mode de réalisation de l'invention comprendre un matériau dopé cascade lumineuse favorisant la fonction photovoltaïque.

Selon un mode de réalisation de la présente invention, illustré par la Figure 6c, un module photovoltaïque 601 comprend une plaque avant 603 comprenant un matériau transparent neutre et revêtue d'un film 663 de matériau dopé cascade lumineuse favorisant la photosynthèse et/ou dopé cascade lumineuse favorisant la fonction photovoltaïque, un substrat arrière 605 comprenant un matériau transparent neutre, et un ensemble de cellules photovoltaïques 607 disposées dans une matrice organique 609 comprenant un matériau transparent neutre et disposée entre la plaque avant 603 et le substrat arrière 605.

Selon une première variante de ce mode de réalisation de la présente invention, l'un au moins de la matrice organique 609 et du substrat arrière 605 comprend un matériau dopé cascade lumineuse favorisant la photosynthèse.

Dans une seconde variante de ce mode de réalisation de l'invention, la matrice organique peut être remplacée par deux films organiques entre lesquels sont disposées les cellules photovoltaïques 607. Dans ce cas, le film organique supérieur vient se substituer au film 663 comprenant le matériau dopé cascade lumineuse. Le film organique inférieur peut dans une variante supplémentaire de ce mode de réalisation de l'invention comprendre un matériau dopé cascade lumineuse favorisant la photosynthèse.

Selon un mode de réalisation de la présente invention, illustré par la Figure 6d, un module photovoltaïque 601 comprend un substrat arrière 605 comprenant un matériau transparent neutre et revêtu d'un film 661 de matériau dopé cascade lumineuse favorisant la photosynthèse, une plaque avant 603 comprenant un matériau transparent neutre et revêtue d'un film 663 de matériau dopé cascade lumineuse favorisant la fonction photovoltaïque, et un ensemble de cellules photovoltaïques 607 disposées dans une matrice organique 609 comprenant un matériau transparent neutre et disposée entre la plaques avant 603 et le substrat arrière 605.

Dans un mode de réalisation particulier de la présente invention, un module photosynthèse 601 comprend une plaque avant 603 et un substrat arrière 605 comprenant du verre extra blanc, ainsi qu'un ensemble de cellules photovoltaïques 607 disposées dans une matrice comprenant de l'éthylène-acétate de vinyle transparent. Le substrat arrière 605 est revêtu d'un film comprenant du polyéthylène dopé cascade lumineuse favorisant la photosynthèse.

Dans un autre mode de réalisation particulier de la présente invention, un module photovoltaïque 601 comprend une plaque avant 603 comprenant du polyméthacrylate de méthyle transparent et un substrat arrière 605 comprenant du polyméthacrylate de méthyle dopé cascade lumineuse favorisant la photosynthèse, ainsi qu'un ensemble de cellules photovoltaïques 607 disposées dans une matrice de polyméthacrylate de méthyle transparent.

Dans un autre mode de réalisation particulier de la présente invention, un module photovoltaïque 601 comprend une plaque avant 603 comprenant du polyméthacrylate de méthyle dopé cascade lumineuse favorisant la fonction photovoltaïque et un substrat arrière 605 comprenant du polyméthacrylate dé méthyle dopé cascade lumineuse favorisant la photosynthèse, ainsi qu'un ensemble de cellules photovoltaïques 607 disposées entre deux films organiques comprenant un matériau transparent neutre.

Selon un autre mode de réalisation de l'invention, un module photovoltaïque comprend une plaque avant 603 comprenant du verre transparent, un substrat arrière 605 comprenant un polymère fluoré transparent, et un ensemble de cellule photovoltaïques 607 disposées entre deux films organiques comprenant de l'éthylène-acétate de vinyle, le film supérieur comprenant un matériau dopé cascade lumineuse favorisant la fonction photovoltaïque et le film inférieur comprenant un matériau dopé cascade lumineuse favorisant la photosynthèse.

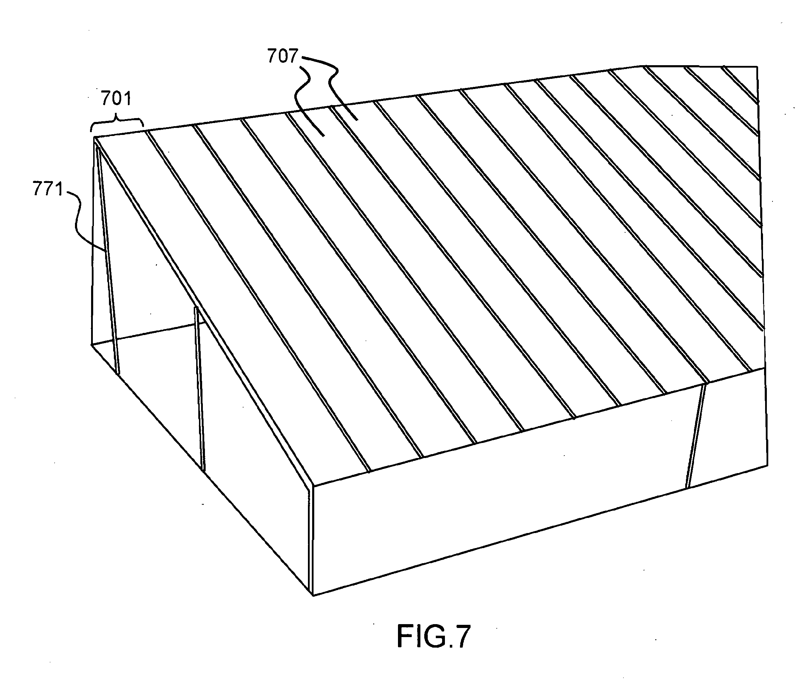

Selon un mode de réalisation de la présente invention, une serre agricole est recouverte sur au moins une partie de sa surface par au moins un module photovoltaïque. La Figure 7 représente un exemple de serre agricole 771 recouverte de modules photovoltaïques 701 comprenant un ensemble de cellules photovoltaïques 707 selon un mode de réalisation de la présente invention.

La présente invention concerne également un procédé de fabrication de modules photovoltaïques du type comprenant une plaque avant destinée à être en contact avec la lumière solaire, un substrat arrière et un ensemble de cellules photovoltaïques (107, 707) disposées entre la plaque avant (103) et le substrat arrière (105). Le procédé comprend au moins les étapes de répartition des cellules photovoltaïques sur le substrat arrière afin que le module photovoltaïque obtenu ait un coefficient de foisonnement compris entre 0,2 et 0,8, et d'incorporation dans ou de revêtement sur l'un au moins de la plaque avant et du substrat arrière d'un matériau dopé cascade lumineuse favorisant la photosynthèse susceptible d'absorber la lumière solaire dans au moins une plage de longueurs d'onde pour la réémettre dans au moins une deuxième plage de longueurs d'onde favorables à la photosynthèse d'au moins une espèce végétale.

L'invention ainsi décrite présente notamment les avantages suivants.

Les modules photovoltaïques selon les modes de réalisation de la présente invention peuvent être bivalents ou multifonctions. Ils favorisent la croissance des espèces végétales placées sous une serre agricole équipée de tels modules, et, concomitamment, ils favorisent la production de courant photoélectrique.

L'invention, bien qu'ayant été décrite dans un exemple particulier de réalisation illustrée par les différentes figures, s'étend à l'ensemble des variantes et modifications apparaissant de manière évidente à l'homme du métier, dans la limite des caractéristiques techniques définies dans les revendications.

## Revendications

1. Module photovoltaïque (101, 701) pour serre agricole comprenant
une plaque avant (103) destinée à être en contact avec la lumière solaire;
un substrat arrière (105); et
un ensemble de cellules photovoltaïques (107, 707) disposées entre la plaque avant (103) et le substrat arrière (105);
**caractérisé en ce que**
le coefficient de foisonnement du module photovoltaïque (101, 701) défini par le rapport de la surface de l'ensemble des cellules photovoltaïques (107) sur la surface totale de collection de photons du module photovoltaïque (101) est compris entre 0,2 et 0,8; et
le module photovoltaïque (101, 701) comprend au moins une couche d'un matériau dopé cascade lumineuse favorisant la photosynthèse c'est à dire susceptible d'absorber la lumière solaire dans au moins une plage de longueurs d'onde pour la réémettre dans au moins une deuxième plage de longueurs d'onde favorables à la photosynthèse d'au moins une espèce végétale.

2. Module photovoltaïque (101, 701) selon la revendication 1, **caractérisé en ce que** l'un au moins de la plaque avant (103) et du substrat arrière (105) forme ou est revêtu de la couche de matériau dopé cascade lumineuse favorisant la photosynthèse.

3. Module photovoltaïque (101, 701) selon l'une quelconque des revendications précédentes, **caractérisé en ce que** l'ensemble des cellules photovoltaïques (107, 707) sont disposées dans une matrice organique (109) ou entre deux films organiques.

4. Module photovoltaïque (101, 701) selon la revendication 3, **caractérisé en ce que** l'un au moins de la matrice organique (109) et des deux films organiques forme la couche de matériau dopé cascade lumineuse favorisant la photosynthèse.

5. Module photovoltaïque (101, 701) selon l'une quelconque des revendications précédentes, **caractérisé en ce que** le matériau dopé cascade lumineuse favorisant la photosynthèse absorbe la lumière solaire dans la plage de longueurs d'onde 300 à 400 nm pour la réémettre dans la plage de longueurs d'onde 410 à 500 nm.

6. Module photovoltaïque (101, 701) selon l'une quelconque des revendications précédentes, **caractérisé en ce que** le matériau dopé cascade lumineuse favorisant la photosynthèse absorbe la lumière solaire dans la plage de longueurs d'onde 510 à 590 nm pour la réémettre dans la plage de longueurs d'onde 600 à 750 nm.

7. Module photovoltaïque (101, 701) selon l'une quelconque des revendications précédentes, **caractérisé en ce que**
la plaque avant (103) et le substrat arrière (105) du module photovoltaïque (101, 701) comprennent du verre; et
au moins l'un de la plaque avant (103) et du substrat arrière (105) est revêtu de la couche de matériau dopé cascade lumineuse favorisant la photosynthèse.

8. Module photovoltaïque (101, 701) selon l'une quelconque des revendications 1 à 6, **caractérisé en ce que**
la plaque avant (103) et le substrat arrière (105) du module photovoltaïque (101, 701) comprennent du polyméthacrylate de méthyle; et
au moins l'un de la plaque avant (103) et du substrat arrière (105) forme la couche de matériau dopé cascade lumineuse favorisant la photosynthèse.

9. Module photovoltaïque (101, 701) selon l'une quelconque des revendications précédentes, **caractérisé en ce que**
le substrat arrière (105) forme ou est revêtu de la couche de matériau dopé cascade lumineuse photosynthèse; et
la plaque avant (103) du module photovoltaïque (101, 701) forme ou est revêtue d'une couche d'un matériau dopé cascade lumineuse favorisant la fonction photovoltaïque susceptible d'absorber la lumière solaire dans au moins une plage de longueurs d'onde pour la réémettre dans au moins une deuxième plage de longueurs d'onde de plus grande sensibilité des cellules photovoltaïques (107, 707).

10. Module photovoltaïque (101, 701) selon l'une quelconque des revendications précédentes, **caractérisé en ce que** la couche de matériau dopé cascade lumineuse favorisant la fonction photovoltaïque ou favorisant la photosynthèse comprend une matrice comprenant au moins un composé choisi dans le groupe comprenant les silicones, les polycarbonates, l'éthylène-acétate de vinyle, le polyéthylène, le polyméthacrylate de méthyle, le polyvinyle butyrale, les verres, et leurs dérivés.

11. Module photovoltaïque (101, 701) selon l'une quelconque des revendications précédentes, **caractérisé en ce que** le matériau dopé cascade lumineuse favorisant la fonction photovoltaïque ou la photosynthèse comprend au moins un composé choisi dans le groupe comprenant les lanthanides, l'ion uranyl, les composés cycliques aromatiques du type à N noyaux, N étant un entier choisi parmi 3, 4, 5 ou plus, et leurs dérivés.

12. Serre agricole (705) **caractérisée en ce qu'**elle est recouverte sur au moins une partie de sa surface par au moins un module photovoltaïque (101, 701) selon l'une quelconque des revendications précédentes.

13. Procédé de fabrication de modules photovoltaïques du type comprenant une plaque avant destinée à être en contact avec la lumière solaire;
un substrat arrière; et
un ensemble de cellules photovoltaïques (107, 707) disposées entre la plaque avant (103) et le substrat arrière (105);
le procédé étant **caractérisé en ce qu'**il comprend au moins les étapes de
répartition des cellules photovoltaïques sur le substrat arrière afin que le module photovoltaïque obtenu ait un coefficient de foisonnement défini par le rapport de la surface de l'ensemble des cellules photovoltaïques (107) sur la surface totale de collection de photons du module photovoltaïque (101) compris entre 0,2 et 0,8; et
incorporation dans ou revêtement sur l'un au moins de la plaque avant et du substrat arrière d'un matériau dopé cascade lumineuse c'est à dire favorisant la photosynthèse susceptible d'absorber la lumière solaire dans au moins une plage de longueurs d'onde pour la réémettre dans au moins une deuxième plage de longueurs d'onde favorables à la photosynthèse d'au moins une espèce végétale.

## Patentansprüche

1. Photovoltaisches Modul (101, 701) für ein landwirtschaftliches Gewächshaus, umfassend
eine vordere Platte (103), die dazu bestimmt ist, mit dem Sonnenlicht in Kontakt zu sein;
ein hinteres Substrat(105) und
eine Gruppe photovoltaischer Zellen (107, 707), die zwischen der vorderen Platte (103) und dem hinteren Substrat (105) angeordnet sind;
**dadurch gekennzeichnet, dass**
der Flächenwirkungsgrad des photovoltaischen Moduls (101, 701), der durch das Verhältnis der Fläche der Gruppe photovoltaischer Zellen (107) auf der Gesamtfläche der Photonenkollektion des photovoltaischen Moduls (101) definiert ist, zwischen 0,2 und 0,8 inbegriffen ist; und
das photovoltaische Modul (101, 701) wenigstens eine Schicht eines gedopten Materials einer Leuchtkaskade umfasst, das die Photosynthese begünstigt, d. h., die geeignet ist, das Sonnenlicht in wenigstens einem Bereich von Wellenlängen zu absorbieren, um es in wenigstens einem zweiten Bereich von Wellenlängen wiederzugeben, die für die Photosynthese wenigstens einer pflanzlichen Art günstig sind.

2. Photovoltaisches Modul (101, 701) gemäß Anspruch 1, **dadurch gekennzeichnet, dass** wenigsten eines der vorderen Platte (103) und des hinteren Substrats (105) die Schicht des gedopten Materials einer Leuchtkaskade bildet oder damit beschichtet ist, die die Photosynthese begünstigt.

3. Photovoltaisches Modul (101, 701) gemäß einem der voranstehenden Ansprüche, **dadurch gekennzeichnet, dass** die Gruppe der photovoltaischen Zellen (107, 707) in einer organischen Matrix (109) oder zwischen zwei organischen Folien angeordnet sind.

4. Photovoltaisches Modul (101, 701) gemäß Anspruch 3, **dadurch gekennzeichnet, dass** wenigstens eines der organischen Matrix (109) und der zwei organischen Folien die Schicht aus gedoptem Material einer Leuchtkaskade bildet, die die Photosynthese begünstigt.

5. Photovoltaisches Modul (101, 701) gemäß einem der voranstehenden Ansprüche, **dadurch gekennzeichnet, dass** das gedopte Material einer Leuchtkaskade, das die Photosynthese begünstigt, das Sonnenlicht in dem Bereich der Wellenlängen 300 bis 400 nm absorbiert, um es in dem Bereich der Wellenlängen 410 bis 500 nm wiederzugeben.

6. Photovoltaisches Modul (101, 701) gemäß einem der voranstehenden Ansprüche, **dadurch gekennzeichnet, dass** das gedopte Material einer Leuchtkaskade, das die Photosynthese begünstigt, das Sonnenlicht in dem Bereich der Wellenlängen 510 bis 590 nm absorbiert, um es in dem Bereich der Wellenlängen 600 bis 750 nm wiederzugeben.

7. Photovoltaisches Modul (101, 701) gemäß einem der voranstehenden Ansprüche, **dadurch gekennzeichnet, dass**
die vordere Platte (103) und das hintere Substrat (105) des photovoltaischen Moduls (101, 701) Glas umfassen; und
wenigstens eine der vorderen Platte (103) und des hinteren Substrats (105) mit der Schicht des gedopten Materials einer Leuchtkaskade beschichtet ist, das die Photosynthese begünstigt.

8. Photovoltaisches Material (101, 701) gemäß Anspruch 1 bis 6, **dadurch gekennzeichnet, dass**
die vordere Platte (103) und das hintere Substrat (105) des photovoltaischen Moduls (101, 701) Methylpolymethacrylat umfassen; und
wenigstens eines der vorderen Platte (103) und des hinteren Substrats (105) die Schicht aus gedoptem Material einer Leuchtkaskade bildet, das die Photosynthese begünstigt.

9. Photovoltaisches Modul (101, 701) gemäß einem der voranstehenden Ansprüche, **dadurch gekennzeichnet, dass**
das hintere Substrat (105) die Schicht des gedopten Materials einer Leuchtkaskade einer Synthese bildet oder damit beschichtet ist; und
die vordere Platte (103) des photovoltaischen Moduls (101, 701) eine Schicht eines gedopten Materials einer Leuchtkaskade bildet oder damit beschichtet ist, die die photovoltaische Funktion begünstigt, die geeignet, das Sonnenlicht in wenigstens einem Bereich von Wellenlängen zu absorbieren, um es in wenigstens einem zweiten Bereich von Wellenlängen mit einer größeren Sensibilität der photovoltaischen Zellen (107, 707) wiederzugeben.

10. Photovoltaisches Modul (101, 701) gemäß einem der voranstehenden Ansprüche, **dadurch gekennzeichnet, dass** die Schicht des gedopten Materials einer Leuchtkaskade, das die photovoltaische Funktion begünstigt oder die Photosynthese begünstigt, eine Matrix umfasst, die wenigstens eine Verbindung umfasst, die aus der Gruppe ausgewählt ist, umfassend Silikone, Polykarbonate, Vinyl-Ethylen-Acetat, Polyethylen, Methylpolymethacrylat, Glas und deren Derivate.

11. Photovoltaisches Modul (101, 701) gemäß einem der voranstehenden Ansprüche, **dadurch gekennzeichnet, dass** das gedopte Material einer Leuchtkaskade, das die photovoltaische Funktion oder die Photosynthese begünstigt, wenigstens eine Verbindung umfasst, die aus der Gruppe ausgewählt ist, umfassend Lanthanide, Uranylion, zyklische aromatische Verbindungen vom Typ mit N Kernen, wobei N eine ganze Zahl ist, die ausgewählt ist aus 3, 4, 5 oder mehr, und ihren Derivaten.

12. Landwirtschaftliches Gewächshaus (705), **dadurch gekennzeichnet, dass** es auf wenigstens einem Teil seiner Fläche mit wenigstens einem photovoltaischen Modul (101, 701) gemäß einem der voranstehenden Ansprüche abgedeckt ist.

13. Herstellungsverfahren von photovoltaischen Modulen von dem Typ, umfassend
eine vordere Platte, die dazu bestimmt ist, mit dem Sonnenlicht in Kontakt zu sein;
ein hintere Substrat; und
eine Gruppe von photovoltaischen Zellen (107, 707), die zwischen der vorderen Platte (103) und dem hinteren Substrat (105) angeordnet sind;
wobei das Verfahren **dadurch gekennzeichnet, ist, dass** es wenigstens die Stufen der
Verteilung der photovoltaischen Zellen auf dem hinteren Substrat umfasst, damit das erhaltene photovoltaische Modul einen Flächenwirkungsgrad hat, der durch das Verhältnis der Fläche der Gruppe der photovoltaischen Zellen (107) auf der Gesamtfläche der Kollektion der Photonen des photovoltaischen Moduls (101) definiert ist, der zwischen 0,2 und 0,8 inbegriffen ist und
Einbindung in oder Beschichtung auf wenigstens einem der vorderen Platte und dem hinteren Substrat eines gedopten Materials einer Leuchtkaskade, d. h., das die Photosynthese begünstigt, die geeignet ist, das Sonnenlicht in wenigstens einem Bereich der Wellenlängen zu absorbieren, um es in wenigstens einem zweiten Bereich der Wellenlängen wiederzugeben, die für die Photosynthese wenigstens einer pflanzlichen Art günstig sind.

## Claims

1. A photovoltaic module (101, 701) for an agricultural greenhouse, comprising
a front plate (103) intended to be in contact with sunlight,
a rear substrate (105); and
a set of photovoltaic cells (107, 707) disposed between the front plate (103) and the rear substrate (105) ;
**characterised in that**
the packing factor of the photovoltaic module (101, 701), defined by the ratio of the surface area of all the photovoltaic cells (107) to the total photon-collection surface area of the photovoltaic module (101), is between 0.2 and 0.8; and
the photovoltaic module (101, 701) comprises at least one layer of luminous cascade doped material promoting photosynthesis, that is to say able to absorb sunlight in at least one range of wavelengths in order to resend it in at least a second range of wavelengths favourable to the photosynthesis of at least one plant species.

2. A photovoltaic module (101, 701) according to claim 1, **characterised in that** at least one from among the front plate (103) and the rear substrate (105) forms or is coated with the layer of luminous cascade doped material promoting photosynthesis.

3. A photovoltaic module (101, 701) according to any one of the preceding claims, **characterised in that** all the photovoltaic cells (107, 707) are disposed in an organic matrix (109) or between two organic films.

4. A photovoltaic module (101, 701) according to claim 3, **characterised in that** at least one from among the organic matrix (109) and the two organic films forms the layer of luminous cascade doped material promoting photosynthesis.

5. A photovoltaic module (101, 701) according to any one of the preceding claims, **characterised in that** the luminous cascade doped material promoting photosynthesis absorbs sunlight in the range of wavelengths 300 to 400 nm in order to resend it in the range of wavelengths 410 to 500 nm.

6. A photovoltaic module (101, 701) according to any one of the preceding claims, **characterised in that** the luminous cascade doped material promoting photosynthesis absorbs sunlight in the range of wavelengths 510 to 590 nm in order to resend it in the range of wavelengths 600 to 750 nm.

7. A photovoltaic module (101, 701) according to any one of the preceding claims, **characterised in that**
the front plate (103) and the rear substrate (105) of the photovoltaic module (101, 701) comprise glass; and
at least one from among the front plate (103) and the rear substrate (105) is coated with the layer of luminous cascade doped material promoting photosynthesis.

8. A photovoltaic module (101, 701) according to any one of claims 1 to 6, **characterised in that**
the front plate (103) and the rear substrate (105) of the photovoltaic module (101, 701) comprise polymethyl methacrylate; and
at least one from among the front plate (103) and the rear substrate (105) forms the layer of luminous cascade doped material promoting photosynthesis.

9. A photovoltaic module (101, 701) according to any one of the preceding claims, **characterised in that**
the rear substrate (105) forms or is coated with the layer of photosynthesis luminous cascade doped material; and
the front plate (103) of the photovoltaic module (101, 701) forms or is coated with a layer of luminous cascade doped material promoting the photovoltaic function able to absorb sunlight in at least one range of wavelengths in order to resend it in at least a second range of wavelengths with greater sensitivity of the photovoltaic cells (107, 707).

10. A photovoltaic module (101, 701) according to any one of the preceding claims, **characterised in that** the layer of luminous cascade doped material promoting the photovoltaic function or promoting photosynthesis comprises a matrix comprising at least one compound chosen from the group comprising silicones, polycarbonates, ethylene vinyl acetate, polyethylene, polymethyl methacrylate, polyvinyl butyral, glasses, and derivatives thereof.

11. A photovoltaic module (101, 701) according to any one of the preceding claims, **characterised in that** the layer of luminous cascade doped material promoting the photovoltaic function or photosynthesis comprises at least one compound chosen from the group comprising lanthanides, the uranyl ion, aromatic cyclic compounds of the type with N rings, N being an integer chosen from 3, 4, 5 or more, and derivatives thereof.

12. An agricultural greenhouse (705), **characterised in that** it is covered over at least part of its surface with at least one photovoltaic module (101, 701) according to any one of the preceding claims.

13. A method for manufacturing photovoltaic modules of the type comprising
a front plate intended to be in contact with sunlight,
a rear substrate; and
a set of photovoltaic cells (107, 707) disposed between the front plate (103) and the rear substrate (105) ;
the method being **characterised in that** it comprises at least the steps of
distribution of the photovoltaic cells on the rear substrate so that the photovoltaic module obtained has a packing factor, defined by the ratio of the surface area of all the photovoltaic cells (107) to the total photon-collection surface area of the photovoltaic module (101), of between 0.2 and 0.8; and
incorporation in or coating on at least one from among the front plate and the rear substrate of luminous cascade doped material, that is to say promoting photosynthesis, able to absorb sunlight in at least one range of wavelengths in order to resend it in at least a second wavelengths favourable to the photosynthesis of at least one plant species.
